# EUROPEAN PATENT SPECIFICATION

(11) **EP 2 222 078 B1**
(45) Date of publication and mention of the grant of the patent: **02.11.2011**
(21) Application number: 10154394.0
(22) Date of filing: 23.02.2010
(51) Int. Cl.: H04N 5/46, H03H 7/12

(54) **Intermediate frequency circuit**
Zwischenfrequenzschaltung
Circuit à fréquence intermédiaire

(30) Priority: 24.02.2009 JP 2009041212
(43) Date of publication of application: 25.08.2010
(73) Proprietor: Alps Electric Co., Ltd., Tokyo 145-8501 (JP)
(72) Inventor: Yamamoto, Masaki, Tokyo 145-8501 (JP)
(74) Representative: Klunker . Schmitt-Nilson . Hirsch

(56) References cited:
- EP-A2- 1 467 494
- US-A1- 2002 176 027
- US-A1- 2004 061 804

## Description

The present invention claims the benefit of Japanese Patent Application JP 2009-041212 filed in the Japanese Patent Office on February 24, 2009,.

### BACKGROUND

### 1. Technical Field

The present invention relates to an intermediate frequency circuit. For example, the present invention relates to an intermediate frequency circuit used for a composite television tuner capable of selectively switching a narrow band or a wide band compatible with an analog scheme and a digital scheme, and receiving an analog television signal and a digital television signal.

### 2. Related Art

According to the related art, a band limit circuit is provided between a mixer for frequency-converting a television signal to an intermediate frequency signal and an amplifier for amplifying the intermediate frequency signal, thereby performing band limitation in an intermediate frequency band. For example, there has been proposed a band limit circuit being tuned to an intermediate frequency signal and attenuating a disturbing signal of an adjacent channel (for example, refer to Japanese Registered Utility Model No. 3103620).

Further, a television tuner using the band limit circuit (intermediate frequency circuit) of the intermediate frequency band includes a composite television tuner compatible with an analog scheme and a digital scheme. It is preferred that the analog scheme can be compatible with a plurality of schemes such as PAL (Phase Alternation by Line) schemes or SECAM (SEquential Couleur Avec Memoire) schemes.

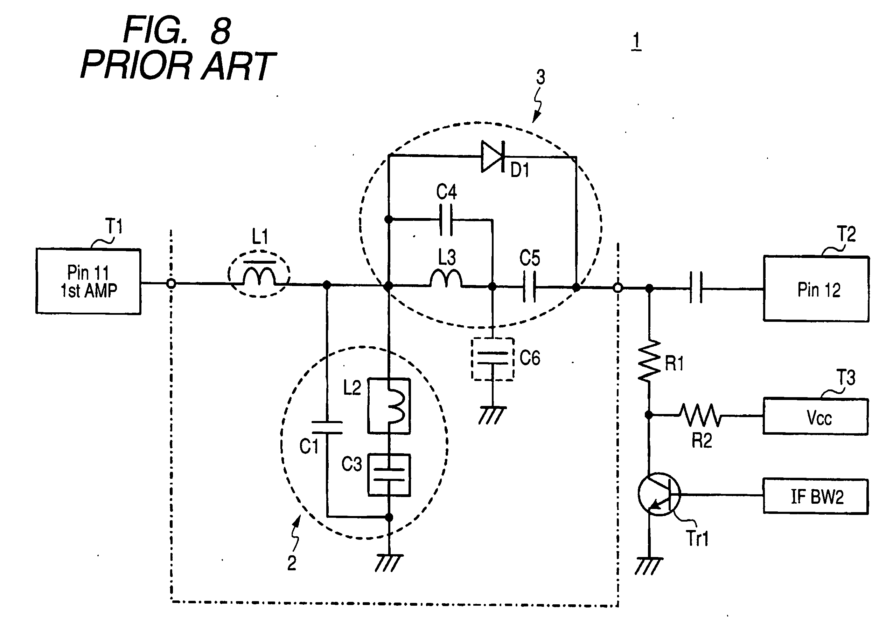

Fig. 8 is a circuit diagram illustrating an intermediate frequency circuit used for the above-described composite television tuner compatible with an analog scheme and a digital scheme. The intermediate frequency circuit 1 shown in Fig. 8 includes an inductor L1 having one end connected to an output terminal T1 of an intermediate frequency amplifier, a tuning circuit 2 provided between the other end of the inductor L1 and an input terminal T2 of a post-stage intermediate frequency amplifier, and a lower adjacent trap circuit 3.

The tuning circuit 2 is connected to the output terminal T1 through the inductor L1, and includes a parallel resonant circuit of a capacitor C1 and an inductor L2. A cold side of the inductor L2 is connected to the ground through a DC cut capacitor C3. The capacitor C3 is set to have a high capacitance value (e.g., 1000PF) to cut a DC voltage.

The lower adjacent trap circuit 3 is connected to a rear stage of the tuning circuit 2 and includes a parallel resonant circuit of an inductor L3 and a capacitor C4. A diode D1 is connected between input and output terminals of the parallel resonant circuit. The output terminal of the parallel resonant circuit is connected to the post-stage intermediate frequency amplifier through a capacitor C5, and is connected to the ground through a capacitor C6. An output terminal of the lower adjacent trap circuit 3 is connected to the ground through a resistor R1 and a collector-emitter of a transistor Tr1. A supply voltage terminal T3 is connected to a connection point between a ground-side end of the resistor R1 and the collector of the transistor Tr1 to apply a supply voltage Vcc through a resistor R2.

According to the intermediate frequency circuit 1, the transistor Tr1 is turned on and off by a driving voltage applied to a base thereof, and a forward bias voltage or a backward bias voltage of the supply voltage Vcc is applied to the diode D1. If the diode D1 is conducted by the forward bias voltage applied to both ends thereof (Fig. 9A), switching to a band (wide band) compatible with the SECAM scheme or the digital scheme is performed, and the intermediate frequency circuit 1 is tuned to an intermediate frequency signal of this band by the tuning circuit 2. Meanwhile, if the diode D1 is opened by the backward bias voltage applied thereto (Fig. 9B), switching to a band (narrow band) compatible with the PAL scheme is performed, the intermediate frequency circuit 1 is tuned to an intermediate frequency signal of this band by the tuning circuit 2, and a disturbing signal of an adjacent channel is attenuated by the lower adjacent trap circuit 3.

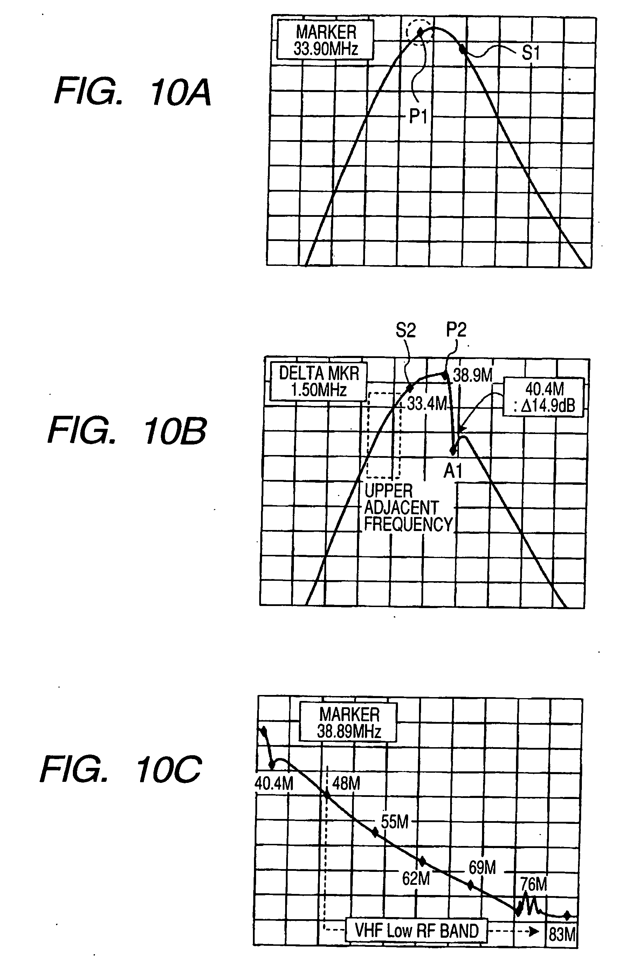

However, according to the intermediate frequency circuit 1 as described above, in the wide band of the SECAM scheme or the digital scheme, although frequency characteristics at low frequencies are emphasized by the characteristics of the tuning circuit 2, a frequency point P1 corresponding to an image frequency is not sufficiently emphasized (Fig. 10A). Further, in the narrow band of the PAL scheme, a frequency band corresponding to a sound frequency adjacent to an upper side in the intermediate frequency band is attenuated to 40.4MHz (A1) by the lower adjacent trap circuit 3, but this attenuation amount is not sufficient. In addition, since the attenuation amount at low frequencies in the intermediate frequency band is also not sufficient, a carrier signal may flow out to a post-stage circuit (Fig. 10B). Moreover, in the PAL scheme, since the attenuation amount at frequencies corresponding to an RF band of VHF Low is also not sufficient, a carrier signal may flow out to a post-stage circuit (Fig. 10C).

Patent application document US 2004/0061804 A1 describes a television receiver including a multi-standard channel filter with a programmable intermediate frequency adapted to receive television signals according to a plurality of standards.

### SUMMARY

An advantage of some aspects of the invention is to provide an intermediate frequency circuit capable of allowing an intermediate frequency signal of a desired band to pass through a post-stage circuit by sufficiently attenuating a disturbing signal of a channel adjacent to the desired band even if the intermediate frequency circuit is used for a composite television tuner capable of selectively switching a narrow band or a wide band compatible with an analog scheme and a digital scheme.

According to an aspect of the invention, there is provided a television tuner as defined in claim 1. Further aspects of the invention ave defined by the dependent claims.

### BRIEF DESCRIPTION OF THE DRAWINGS

Fig. 1 is a circuit diagram illustrating the configuration of a composite television tuner according to an embodiment of the invention.
Fig. 2 is a circuit diagram illustrating the configuration of an intermediate frequency circuit according to an embodiment.
Figs. 3A and 3B are equivalent circuit diagrams illustrating the operation of an intermediate frequency circuit according to an embodiment.
Figs. 4A and 4B are equivalent circuit diagrams illustrating characteristics of a lower adjacent trap circuit of an intermediate frequency circuit according to an embodiment.
Figs. 5A to 5C are graphs illustrating simulation results of an intermediate frequency circuit according to an embodiment.
Figs. 6A and 6B are graphs illustrating simulation results of an intermediate frequency circuit according to a comparison example.
Figs. 7A to 7D are graphs illustrating an intermediate frequency circuit according to a modification of an embodiment.
Fig. 8 is a circuit diagram illustrating the configuration of an intermediate frequency circuit according to the related art.

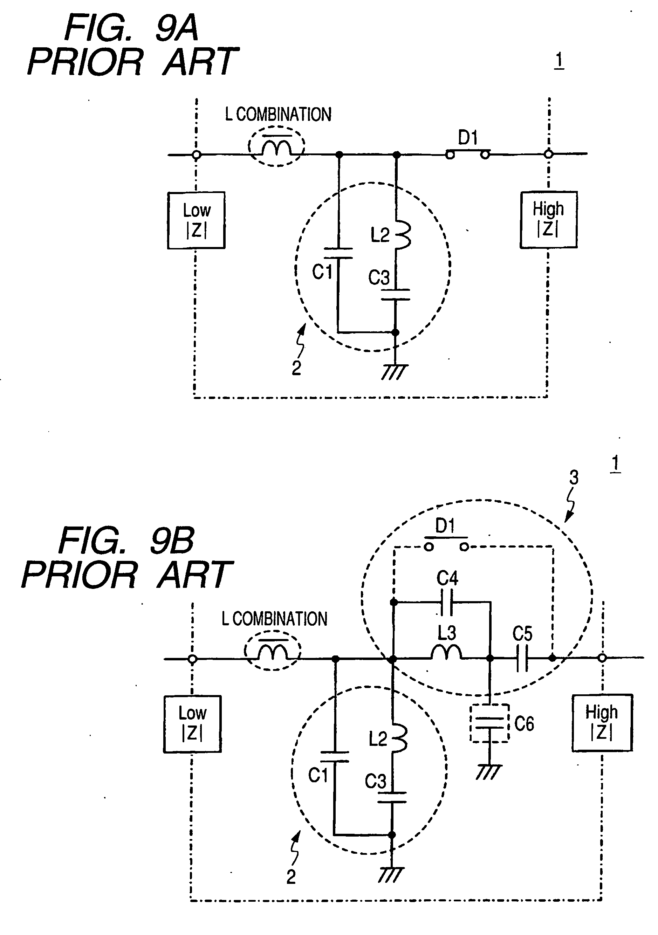

Figs. 9A and 9B are equivalent circuit diagrams illustrating the operation of an intermediate frequency circuit according to the related art.
Figs. 10A to 10C are graphs illustrating problems of the related art.

### DESCRIPTION OF EXEMPLARY EMBODIMENTS

An exemplary embodiment of the invention will be described in detail with reference to the accompanying drawings. An intermediate frequency circuit according to the embodiment of the invention is used for a composite television tuner capable of selectively switching a narrow band or a wide band compatible with an analog scheme and a digital scheme, and receiving an analog television signal and a digital television signal. An analog scheme includes a plurality of schemes such as PAL (Phase Alternation by Line) schemes or SECAM (SEquential Couleur Avec Memoire) schemes.

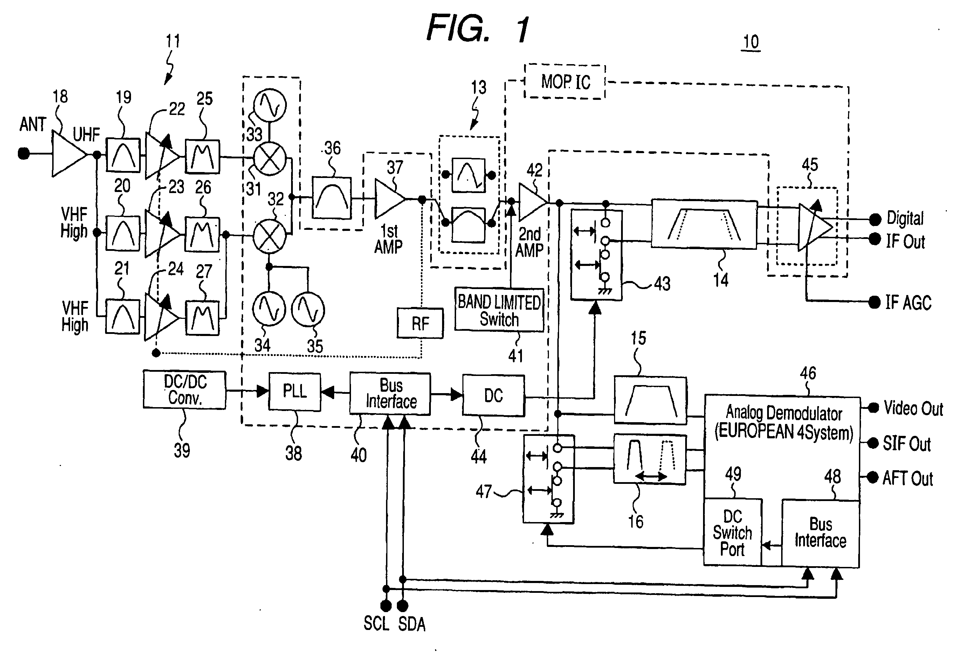

Fig. 1 is a circuit diagram illustrating the configuration of a composite television tuner (hereinafter, referred to as a tuner) according to the embodiment of the invention. As illustrated in Fig. 1, the tuner 10 includes an RF tuning circuit 11 tuned to a television signal, an intermediate frequency circuit 13, a digital SAW filter 14, an analog SAW filter 15 for an image signal, and an analog SAW filter 16 for a sound signal.

The RF tuning circuit 11 includes a high frequency amplifier 18 that amplifies television signals (reception signals) received in an analog format, a band-pass filter (BPF) 19 that allows the reception signal of a UHF band to pass therethrough, two BPFs 20 and 21 that allow the reception signals of a VHF band to pass therethrough, amplifiers 22 to 24 that amplify the reception signals of each band having passed the BPFs 19 to 21, and RF filters 25 to 27. The reception signals received in the analog format are amplified by the high frequency amplifier 18 to a predetermined signal level, and are output to the BPFs 19 to 21, respectively. After the reception signal of the UHF band having passed through the BPF 19 is amplified by the amplifier 22 to a predetermined signal level, the amplified signal passes through the RF filter 25, and is transmitted to a mixer 31. Further, after the reception signals of the VHF band having passed through the BPFs 20 and 21 are amplified by the amplifiers 23 and 24 to a predetermined signal level, the amplified signals pass through the RF filters 26 and 27, and are transmitted to a mixer 32.

In order to generate a stable oscillation frequency signal, oscillation frequencies of local oscillators 33 to 35 are fixed by a PLL circuit 38. Power is supplied from a DC converter 39 to the PLL circuit 38 and control signals (SCL & SDA) are input from a control circuit (not shown) to the PLL circuit 38 through a bus interface 40. In the mixer 31, the reception signal of the UHF band having passed through the RF filter 25 is mixed with a local oscillation signal generated by the local oscillator 33, so that an intermediate frequency signal is generated. Further, in the mixer 32, the reception signals of the VHF band having passed through the RF filters 26 and 27 are mixed with local oscillation signals generated by the local oscillators 34 and 35, so that an intermediate frequency signal is generated. The intermediate frequency signal generated by the mixer 32 passes through a BPF 36, is amplified by a first intermediate frequency amplifier 37 to a predetermined signal level, and is output to the intermediate frequency circuit 13.

In the intermediate frequency circuit 13, a bandwidth is switched between the narrow band compatible with the PAL scheme and the wide band compatible with the SECAM scheme and the digital scheme by a DC voltage applied from a band limit switch 41. Then, the intermediate frequency circuit 13 is tuned to the intermediate frequency signal of a switched desired band and removes a disturbing signal adjacent to the intermediate frequency signal. The intermediate frequency signal, from which the disturbing signal is removed by the intermediate frequency circuit 13, is amplified by a second intermediate frequency amplifier 42 to a predetermined signal level, and is output to the digital SAW filter 14 or the analog SAW filters 15 and 16. Further, a detailed description of the intermediate frequency circuit 13 will be described later.

The digital SAW filter 14 serves as a band switching type digital SAW filter which allows the intermediate frequency signal amplified by the second intermediate frequency amplifier 42 to pass therethrough, and a band is switched by a band change switch 43. The band change switch 43 switches connection and non-connection of two pins of the digital SAW filter 14 by a voltage applied from a DC switch port 44, so that the band is switched. The intermediate frequency signal having passed through the digital SAW filter 14 is amplified by a gain control amplifier 45 to a predetermined signal level, and is output to a digital demodulation circuit (not shown).

The analog SAW filter 15 for an image allows only an image signal of the intermediate frequency signal amplified by the second intermediate frequency amplifier 42 to pass therethrough, so that the image signal is output to an analog demodulator 46. The analog SAW filter 16 for sound is configured such that a pass band thereof is switched by a change switch 47. The change switch 47 switches connection and non-connection of two pins of the digital SAW filter 16 for sound by a voltage applied from a DC switch port 49 connected to a bus interface 48, so that a sound band is switched. The digital SAW filter 16 for sound allows only a sound signal of the intermediate frequency signal amplified by the second intermediate frequency amplifier 42 to pass therethrough, so that the sound signal is output to the analog demodulator 46. The image signal and the sound signal input to the analog demodulator 46 are output to an analog signal processing circuit (not shown). Further, in the tuner 10, the mixers 31 and 32, the local oscillators 33 to 35, the first intermediate frequency amplifier 37, the PLL circuit 38, the bus interface 40, the band limit switch 41, the second intermediate frequency amplifier 42, the DC switch port 44 and the gain control amplifier 45 constitute an integrated circuit MOP IC.

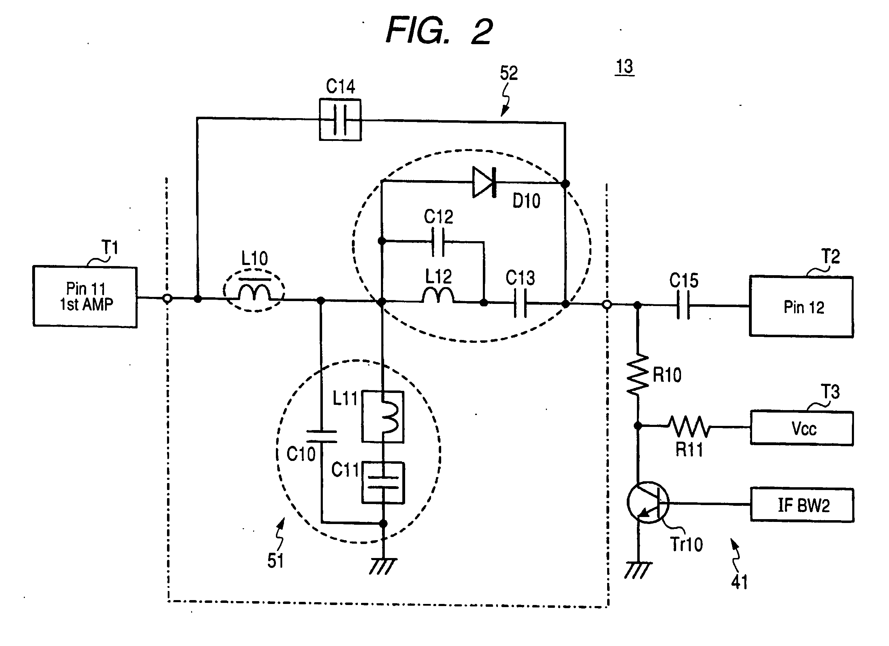

Next, the intermediate frequency circuit 13 will be described with reference to Fig. 2. Fig. 2 is a circuit diagram illustrating the configuration of the intermediate frequency circuit 13. The intermediate frequency circuit 13 shown in Fig. 2 includes an inductor (first inductor) L10, which has one end connected to an output terminal T1 of the first intermediate frequency amplifier 37, and a tuning/upper adjacent trap circuit (intermediate frequency tuning circuit) 51 and a lower adjacent trap circuit 52, which are provided between the other end of the inductor L10 and an input terminal T2 of the second intermediate frequency amplifier 42. Since the output terminal T1 of the first intermediate frequency amplifier 37 has low impedance as compared with the input terminal T2 of the second intermediate frequency amplifier 42, impedance matching is achieved between the output terminal T1 and the input terminal T2 by L coupling of the inductor L10.

The tuning/upper adjacent trap circuit 51 includes a parallel resonant circuit of a capacitor C10 and an inductor L11, and a series resonant circuit of the inductor L11 and a capacitor C11. The parallel resonant circuit has frequency characteristics tuned to an intermediate frequency signal of a relatively wide band compatible with the SECAM scheme and the digital scheme, and the series resonant circuit serves as an upper adjacent trap circuit that attenuates a frequency band of an upper adjacent channel corresponding to a lower side of the intermediate frequency band. The inductor L11 has one end connected to a connection point between the other end of the inductor L10 and the lower adjacent trap circuit 52, and the other end serially connected to one end of the capacitor C11. The other end of the capacitor C11 is grounded. The capacitance of the capacitor C11 constituting the series resonant circuit together with the inductor L11 is set to 100PF (e.g., about 40PF) or less by taking Q characteristics of a trap circuit into consideration. One end of the capacitor C10 is connected to the other end of the inductor L10 and the other end of the capacitor C10 is connected between the capacitor C11 and the ground.

The lower adjacent trap circuit 52 includes a parallel resonant circuit provided with an inductor L12 (second inductor) and a capacitor C12 (second capacitance), a diode D10 connected between input and output terminals of the parallel resonant circuit, and a capacitor C13 (third capacitance) provided between the output terminal of the parallel resonant circuit and the input terminal T2 of the second intermediate frequency amplifier 42. Further, a capacitor C14 (first capacitance) is provided between the inductor L10 and the input terminal T2.

The inductor L12 has one end connected to a connection point between the other end of the inductor L10 and one end of the inductor L11, and the other end connected to one end of the capacitor C13. The other end of the capacitor C13 is connected to one end of the inductor L12, and is connected to the input terminal T2 through a capacitor C15. The diode D10 has an anode connected to the input terminal of the parallel resonant circuit (C12 and L12) and a cathode connected to the output terminal of the parallel resonant circuit (C12 and L12). The capacitor C14 has one end connected to a connection point between the output terminal T1 and one end of the inductor L10, and the other end connected to a cathode-side of the diode D10.

An output terminal of the lower adjacent trap circuit 52 is grounded through a resistor R10 and a collector-emitter of a transistor Tr10. A supply voltage terminal T3 is connected between the collector of the transistor Tr10 serving as the band limit switch (switch means) 41 and the resistor R10 to apply a supply voltage Vcc through a resistor R11. According to the intermediate frequency circuit 13, the transistor Tr10 is turned on and off by a driving voltage applied to a base thereof, and a forward bias voltage or a backward bias voltage is applied to both ends of the diode D10. If the diode D10 is conducted by the forward bias voltage applied thereto, switching to a band (wide band) compatible with the SECAM scheme or the digital scheme is performed. If the diode D10 is opened by the backward bias voltage applied thereto, switching to a band (narrow band) compatible with the PAL scheme is performed.

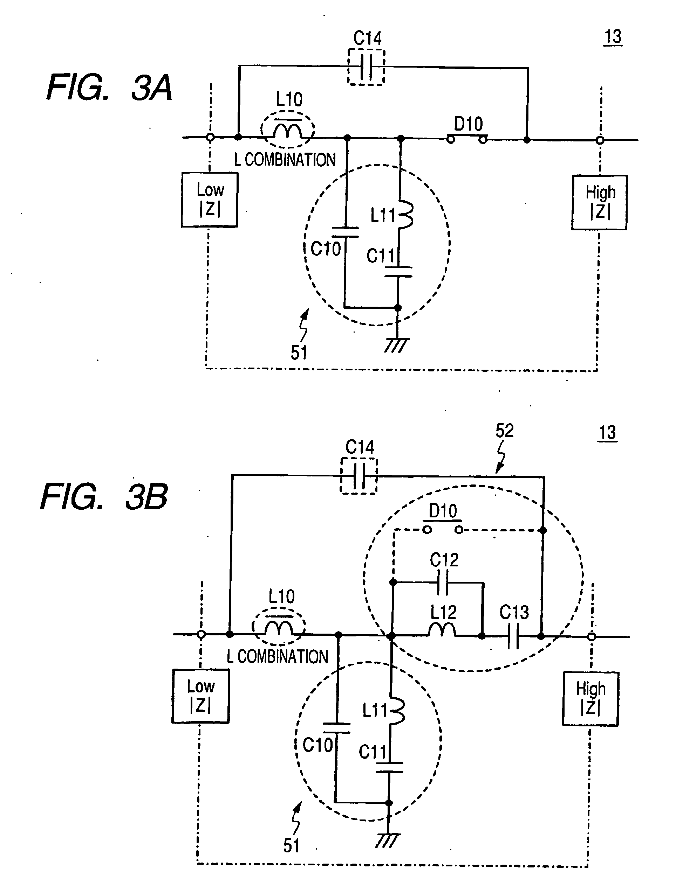

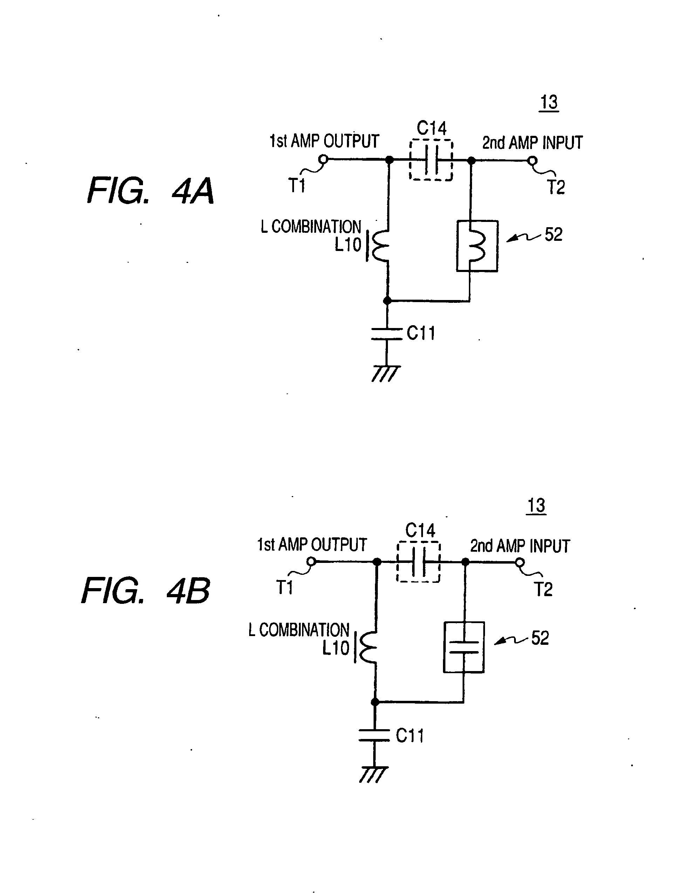

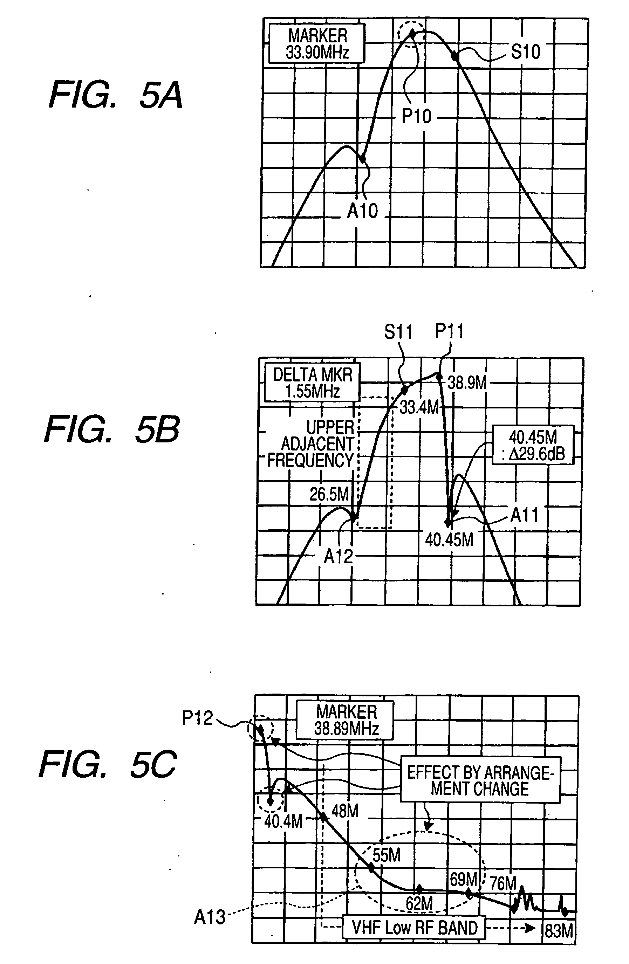

Then, an operation of the intermediate frequency circuit 13 will be described with reference to Figs. 3 to 5. Figs. 3A to 3B are equivalent circuit diagrams illustrating the operation of the intermediate frequency circuit according to the embodiment. Fig. 3A illustrates the operation of the intermediate frequency circuit 13 when the diode D10 is conducted and Fig. 3B illustrates the operation of the intermediate frequency circuit 13 when the diode D10 is opened. Figs. 4A to 4B are equivalent circuit diagrams including inductance and capacitance of the lower adjacent trap circuit. Fig. 4A illustrates an equivalent circuit in a band lower than an inductive trap frequency, and Fig. 4B illustrates an equivalent circuit in a band higher than a capacitive trap frequency. Figs. 5A to 5C are graphs illustrating simulation results of the intermediate frequency circuit.

As illustrated in Fig. 3A, if the diode D1 is conducted and the switching to the band (wide band) compatible with the SECAM scheme and the digital scheme is performed, the intermediate frequency tuning circuit including the capacitor C10 and the inductor L11 is tuned to the intermediate frequency signal, and the upper adjacent trap circuit including the inductor L11 and the capacitor C11 attenuates the frequency band of the upper adjacent channel corresponding to the lower side of the intermediate frequency band. As a result, as illustrated in Fig. 5A, a trap is formed in the vicinity of a frequency indicated by A10 according to series resonant characteristics of the inductor L11 and the capacitor C11, and the vicinity of a frequency point P10 corresponding to an image signal is emphasized according to coupling characteristics of the inductor L10 and tuning characteristics of the capacitor C10 and the inductor L11.

Meanwhile, as illustrated in Fig. 3B, if the diode D1 is opened and the switching to the band (narrow band) compatible with the PAL scheme is performed, the intermediate frequency tuning circuit including the capacitor C10 and the inductor L11 is tuned to the intermediate frequency signal, the upper adjacent trap circuit including the inductor L11 and the capacitor C11 attenuates the frequency band of the upper adjacent channel corresponding to the lower side of the intermediate frequency band, and the lower adjacent trap circuit including the inductor L12 and the capacitor C12 attenuates the frequency band of the lower adjacent channel corresponding to the upper side of the intermediate frequency band. Herein, as illustrated in Figs. 4A to 4B, the lower adjacent trap circuit serves as a inductive (L) load with respect to the entire circuit in frequencies lower than a trap frequency while serving as a capacitive (C) load with respect to the entire circuit in frequencies higher than the trap frequency. Thus, in the low frequencies, the LC resonant circuit of the lower adjacent trap circuit serving as the inductive load and the capacitor C14 is provided between the input terminal T2 of the second intermediate frequency amplifier 42 and the ground (Fig. 4A), so that the vicinity (P) of a frequency corresponding to an image signal is further emphasized by the resonance characteristics of the LC resonant circuit. In the high frequencies, the LC resonant circuit of the lower adjacent trap circuit serving as the capacitive load, the capacitor C14 and the inductor L10 for L coupling is formed on a signal line (Fig. 4B), so that high frequencies can be significantly attenuated by the resonance characteristics of the LC resonant circuit.

As a result, as illustrated in Fig. 5B, a trap was formed in the vicinity of a frequency indicated by A11 due to the attenuation effect of high frequencies caused by the arrangement change of the capacitor C14, the attenuation amount of a sound frequency adjacent to an upper side of the intermediate frequency band was also sufficient, so that a carrier signal can be prevented from flowing out to a post-stage circuit. Further, the vicinity of a frequency indicated by A12 was attenuated by series resonance characteristics of the inductor L11 and the capacitor C11, so that a carrier signal can be prevented from flowing out to a post-stage circuit. In addition, as illustrated in Fig. 5C, a trap was formed in the vicinity of a frequency indicated by A13 due to the attenuation effect of high frequencies caused by the arrangement change of the capacitor C14, and the RF band of VHF Low was attenuated, so that a carrier signal can be prevented from flowing out to a post-stage circuit.

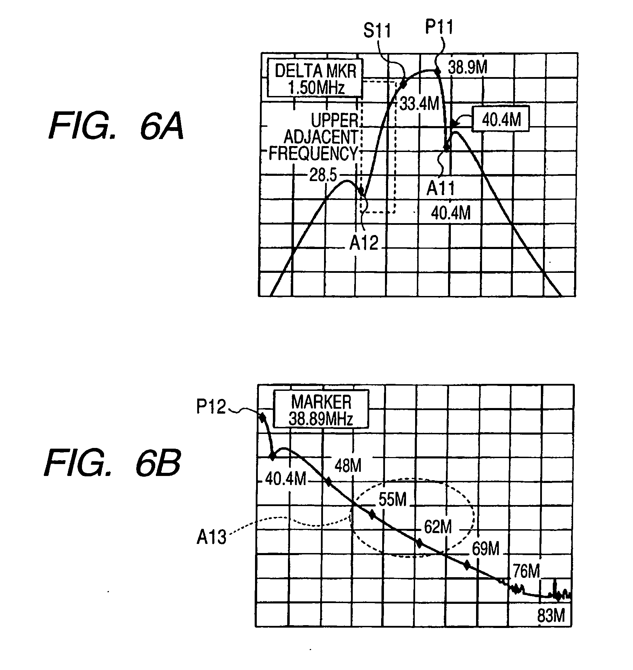

Moreover, when the capacitor C14 was removed from the intermediate frequency circuit 13, as illustrated in Fig. 6A, it can be understood that the attenuation amount of the upper adjacent frequency band corresponding to the lower side of the intermediate frequency band was not affected thereby, but the attenuation amount of the lower adjacent frequency band corresponding to the upper side of the intermediate frequency band was affected thereby. Further, as illustrated in Fig. 6B, it can be understood that the attenuation amount in the RF band of VHF Low was also affected thereby. In this regard, the attenuation amount of the lower adjacent frequency band and the attenuation amount of the RF band of VHF Low was determined by the lower adjacent trap circuit and the capacitor C14.

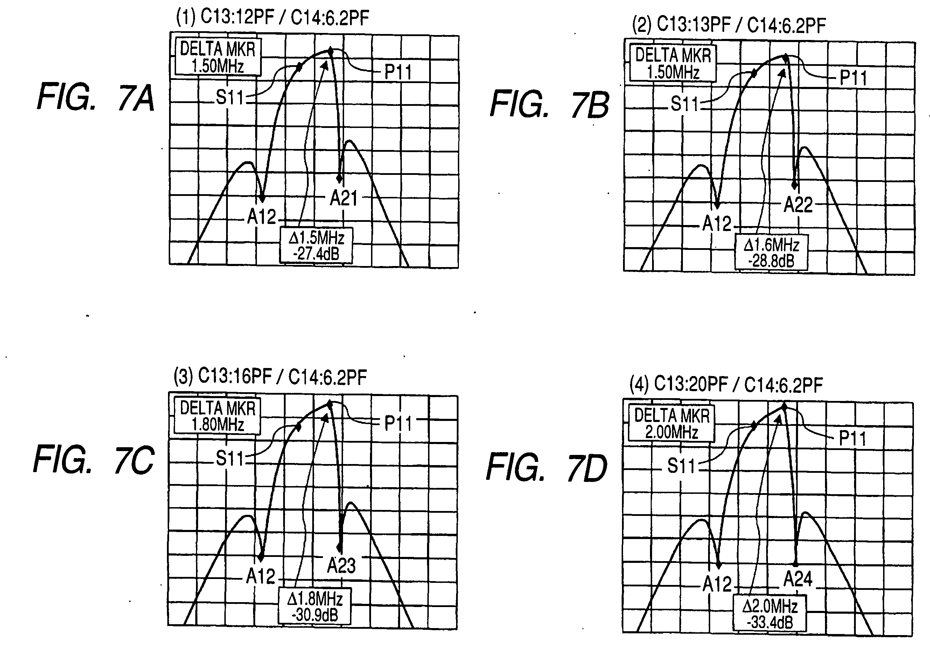

Hereinafter, the relationship between the attenuation amount and the frequency range of a frequency point P11 and an attenuation pole A when the capacitance of the capacitor C13 of the intermediate frequency circuit 13 is changed will be described with reference to Fig. 7. Referring to Fig. 7, the capacitance of the capacitor C13 is changed in the range of 12PF to 20PF and the capacitance of the capacitor C14 is set to 6.2PF. As illustrated in Figs. 7A to 7D, as the capacitance of the capacitor C13 is increased, the attenuation amount of the frequency point P11 and the attenuation pole A (A21 to A24) is increased, and the frequency range of the frequency point P11 and the attenuation pole A is increased. Consequently, if the capacitance of the capacitor C13 is reduced, since the attenuation amount with respect to the frequency point P11 is reduced, it is preferred to set the capacitance of the capacitor C13 by taking the setup position of a trap and the attenuation amount into consideration.

It should be understood by those skilled in the art that various modifications, combinations, sub-combinations and alterations may occur depending on design requirements and other factors insofar as they are within the scope of the appended claims.

The invention can be applied to a composite television tuner capable of selectively switching a narrow band or a wide band compatible with an analog scheme and a digital scheme.

## Claims

1. Television tuner (10), comprising a RF tuning circuit, a mixing circuit (31, 32) and an intermediate frequency circuit (13) connected to a rear stage of said mixing circuit (31, 32) the intermediate frequency circuit (13) comprising:
a first inductor (L10) having one end connected to the mixing circuit (31, 32);
an intermediate frequency tuning circuit (51) connected between the other end of the first inductor (L10) and a ground; and
a trap circuit (52) for lower adjacent channel attenuation, being connected between the other end of the first inductor (L10) and an output terminal,
wherein a first capacitor (C14) is connected between the one end of the first inductor and the output terminal, the trap circuit (52) for lower adjacent channel attenuation has an inductive impedance in a frequency lower than a trap resonance frequency, and a capacitive impedance in a frequency higher than the trap resonance frequency, **characterized in that** the television tuner (10) is configured to receive an analog PAL signal, an analog SECAM signal and a terrestrial digital signal, a switch means (DMTr10) is connected to both ends of the trap circuit (52) for lower adjacent channel attenuation, and the switch means is turned off when the analog PAL signal is received and is turned on when the analog SECAM signal or the terrestrial digital signal is received.

2. The television tuner according to claim 1, wherein the trap circuit (52) for lower adjacent channel attenuation includes:
a parallel resonant circuit including a second inductor (L12) and a second capacitor (C12); and
a third capacitor (C13) serially connected to the parallel resonant circuit.

3. The television tuner according to claim 1 or 2, wherein the intermediate frequency tuning circuit (51) has a trap function for upper adjacent channel attenuation, for attenuating a channel adjacent to an upper side of an intermediate frequency band.

## Patentansprüche

1. Fernsehtuner (10) umfassend eine RF-Abstimmschaltung, eine Mischschaltung (31,32) und eine Zwischenfrequenzschaltung (13), die an die Endstufe der Mischschaltung (31,32) angeschlossen ist, wobei die Zwischenfrequenzschaltung (13) umfasst:
eine erste Induktivität (L10), die mit einem Ende an die Mischschaltung (31,32) angeschlossen ist;
eine Zwischenfrequenz-Abstimmschaltung (51), die zwischen dem anderen Ende der Induktivität (L10) und Schaltungsmasse liegt;
einen Sperrkreis (52) zur Dämpfung eines unteren Nachbarkanals, angeschlossen zwischen dem anderen Ende der ersten Induktivität (L10) und einem Ausgangsanschluss, wobei die Kapazität (C14) zwischen dem einen Ende der ersten Induktivität und dem Ausgangsanschluss liegt, der Sperrkreis (52) zum Dämpfen eines unteren Nachbarkanals eine induktive Impedanz bei einer Frequenz unterhalb einer Sperresonanzfrequenz aufweist, und eine kapazitive Impedanz bei einer Frequenz oberhalb der Sperrresonanzfrequenz besitzt, **dadurch gekennzeichnet dass**, der Fernsehtuner (10) konfiguriert ist zum Empfangen eines Analog-PAL-Signals, eines Analog-SECAM-Signals und eines terristischen Digitalsignals, eine Schalteinrichtung (D11, Tr10) an die beiden Enden des Sperrkreises (52) zur Dämpfung eines unteren Nachbarkanals angeschlossen ist, und die Schalteinrichtung ausgeschaltet wird, wenn das Analog-PAL-Signal empfangen wird, und eingeschaltet wird, wenn das Analog-SECAM-Signal oder das terristische Digitalsignal empfangen wird.

2. Fernsehtuner nach Anspruch 1 bei dem der Sperrkreis (52) zum Dämpfen eines unteren Nachbarkanals enthält:
einen Parallesresonanzkreis mit einer zweiten Induktivität (L12) und einer zweiten Kapazität (C12);
eine dritte Kapazität (C13), die in Serie zu dem Parallelresonanzkreis geschaltet ist.

3. Fernsehtuner nach Anspruch 1 oder 2, bei dem die Zwischenfrequenz-Abstimmschaltung (51) eine Sperrfunktion zur Dämpfung eines oberen Nachbarkanals aufweist, um einen Kanal benachbart zu einer Oberseite eines Zwischenfrequenzbands zu dämpfen.

## Revendications

1. Syntoniseur de télévision (10) comprenant un circuit d'accord de radiofréquence, un circuit mélangeur (31, 32) et un circuit de fréquence intermédiaire (13) connecté à un étage arrière dudit circuit mélangeur (31, 32), le circuit de fréquence intermédiaire (13) comprenant :
une première inductance (L10) ayant une extrémité connectée au circuit mélangeur (31, 32) ;
un circuit d'accord de fréquence intermédiaire (51) connecté entre l'autre extrémité de la première inductance (L10) et une masse ; et
un circuit réjecteur (52) pour l'atténuation de voie adjacente inférieure, connecté entre l'autre extrémité de la première inductance (L10) et une borne de sortie,
dans lequel un premier condensateur (C14) est connecté entre la première extrémité de la première inductance et la borne de sortie, le circuit réjecteur (52) pour l'atténuation de voie adjacente inférieure a une impédance inductive dans une fréquence inférieure à une fréquence de résonance de réjecteur, et une impédance capacitive dans une fréquence supérieure à la fréquence de résonance de réjecteur, **caractérisé en ce que** le syntonisateur de télévision (10) est configuré pour recevoir un signal PAL analogique, un signal SECAM analogique et un signal numérique terrestre, un moyen de commutation (D11, Tr10) est connecté aux deux extrémités du circuit réjecteur (52) pour l'atténuation de voie adjacente inférieure, et le moyen de commutation est mis hors tension quand le signal PAL analogique est reçu et est mis sous tension quand le signal SECAM analogique ou le signal numérique terrestre est reçu.

2. Syntoniseur de télévision selon la revendication 1, dans lequel le circuit réjecteur (52) pour l'atténuation de voie adjacente inférieure comprend :
un circuit résonnant parallèle comprenant une deuxième inductance (L12) et un deuxième condensateur (C12) ; et
un troisième condensateur (C13) connecté en série au circuit résonnant parallèle.

3. Syntoniseur de télévision selon la revendication 1 ou 2, dans lequel le circuit d'accord de fréquence intermédiaire (51) comporte une fonction de réjection pour l'atténuation de voie adjacente supérieure, pour atténuer une voie adjacente à un côté supérieur d'une bande de fréquence intermédiaire.
